Europäisches Patentamt

European Patent Office

Office européen des brevets

(11) Veröffentlichungsnummer: **0 381 088**

**A1**

## (12) EUROPÄISCHE PATENTANMELDUNG

(21) Anmeldenummer: **90101651.9**

(22) Anmeldetag: **27.01.90**

(51) Int. Cl.5: **H05K 13/00**

(30) Priorität: **31.01.89 DE 8901036 U**
    **14.02.89 DE 8901638 U**

(43) Veröffentlichungstag der Anmeldung:
    **08.08.90 Patentblatt 90/32**

(84) Benannte Vertragsstaaten:
    **AT BE CH DK ES FR GB GR IT LI LU NL SE**

(71) Anmelder: **Frost, Günther**
    **Friedrich-Ebert-Strasse 29**
    **D-8400 Regensburg(DE)**

(72) Erfinder: **Frost, Günther**
    **Friedrich-Ebert-Strasse 29**
    **D-8400 Regensburg(DE)**

(74) Vertreter: **Graf, Helmut, Dipl.-Ing. et al**
    **Greflinger Strasse 7 Postfach 382**
    **D-8400 Regensburg(DE)**

(54) **Vorrichtung zum Zertrennen eines mehrere gedruckte Schaltkreise aufweisenden plattenförmigen Nutzens.**

(57) Eine Vorrichtung zum Zertrennen eines mehrere gedruckte Schaltkreise aufweisenden plattenförmigen Nutzens besitzt an einem Vorrichtungsgestell (8) einen ersten Trennbacken (22) mit einer ersten keilartigen Längskante (24) sowie einen zweiten Trennbacken (20) mit einer zweiten, ebenfalls keilartigen Längskante (21). Weiterhin ist ein Antrieb (25-31) vorgesehen, mit dem zumindest der erste Trennbak-ken (22) in einer senkrecht zur ersten und zweiten Längskante verlaufenden Achsrichtung zwischen einer Ausgangsposition und einer Arbeitsposition bewegbar ist. Für ein schonendes Trennen besitzen die Trennbacken in beiden vorgenannten Positionen einen Abstand voneinander, in der Arbeitsposition jedoch einen Abstand (x) der kleiner ist als der Abstand (X) in der Ausgangsposition.

Fig.1

EP 0 381 088 A1

Die Erfindung bezieht sich auf eine Vorrichtung gemäß Oberbegriff Patentanspruch 1.

Insbesondere beim automatischen Bestücken von elektrischen Schaltkreisen ist es üblich, großformatigere Platten bzw. Nutzen zu verwenden, von denen jeder eine Vielzahl von gedruckten Schaltkreisen aufweist, welche in dem verwendeten Bestückungsautomat in der erforderlichen Weise mit elektrischen Bauelementen bestückt werden. Erst nach dem Bestücken erfolgt dann das Trennen des plattenförmigen Nutzens in die einzelnen Schaltkreise. Für dieses Trennen ist der plattenförmige Nutzen vorzugsweise an beiden Oberflächenseiten vorgeritzt, d.h. mit jeweils entlang der Trennlinien verlaufenden nutenförmigen Vertiefungen versehen, wobei bei einem an beiden Oberflächenseiten vorgeritzten Nutzen jede nutenförmige Vertiefungen an einer Oberflächenseite deckungsgleich mit einer nutenförmigen Vertiefung an der anderen Oberflächenseite liegt.

Grundsätzlich ist es auch möglich, den mehrere gedruckte Schaltkreise aufweisenden Nutzen vor dem Bestücken dieser Schaltkreise zu zertrennen. Unabhängig davon, ob nun der Nutzen vor dem Bestücken oder nach dem Bestücken in die einzelnen Schaltkreise zertrennt wird, besteht ein wesentliches Problem darin, daß beim Trennen des Nutzens auf diesen möglichst keine Kräfte, insbesondere auch keine Biege- oder Torsionskräfte ausgeübt werden dürfen, die zu Rissen in den Leiterbahnen der gedruckten Schaltkreise führen könnten.

Aufgabe der Erfindung ist es, eine Vorrichtung aufzuzeigen, mit der bei hoher Betriebssicherheit ein schonendes Zertrennen des Nutzens in die einzelnen Schaltkreise möglich ist.

Zur Lösung dieser Aufgabe ist eine Vorrichtung erfindungsgemäß entsprechend dem kennzeichnenden Teil des Patentanspruches 1 ausgebildet.

Da bei der erfindungsgemäßen Vorrichtung die Trennbacken bzw. deren Längskanten in der Arbeitsposition einen Abstand voneinander aufweisen, erfolgt das Zertrennen des jeweiligen Nutzens mit der erfindungsgemäßen Vorrichtung nicht durch Schneiden des Materiales dieses Nutzens, sondern das Material des Nutzens wird mit den Trennbacken an der jeweiligen Trennstelle keilartig auseinandergedrückt bzw. auseinandergequetscht. Hierdurch wird ein besonders schonendes Trennen erreicht, welches Spannungen im Material des Nutzens, in den Leiterbahnen und auch in solchen Bauteilen (z.B. SMD-Bauteilen) vermeidet, die an den Leiterbahnen oder am Nutzen befestigt sind. Bei der erfindungsgemäßen Vorrichtung wird beim Trennen des Nutzens zumindest ein Trennbacken auf den anderen Trennbacken derart zubewegt, daß die Längskanten der Trennbacken stets parallel zueinander liegen. Diese Bewegung der Trennbacken ist zumindest äußerst zweckmäßig, da diese Bewegung ebenfalls zur Vermeidung von Spannungen im Nutzen, in den Leiterbahnen sowie in den Bauelementen wesentlich beiträgt.

Die erfindungsgemäße Vorrichtung, die im praktischen Einsatz so verwendet wird, daß die Trennbacken mit ihren Längskanten in horizontaler Richtung angeordnet sind und sich der erste Trennbacken in vertikaler Richtung über den zweiten Trennbacken befindet, hat eine Vielzahl von Vorteilen.

Ein Vorteil der Vorrichtung besteht darin, daß durch den nicht nur beidseitig in der dritten Achsrichtung, sondern auch in der ersten Achsrichtung im Bereich eines Endes der Trennbacken bzw. deren Längskanten offenen Arbeitsraum ein Einschieben des jeweiligen Nutzens in den zwischen den Trennbacken gebildeten Trennspalt in der ersten Achsrichtung, d.h. in Richtung der Längskanten der Trennbacken erfolgen kann. Hierdurch ist es selbst bei mit größeren Bauelementen bestücktem Nutzen möglich, den Abstand zwischen den Längskanten der Trennbacken in der Ausgangsposition so klein zu halten, daß eine Verletzungsbzw. Unfallgefahr nicht besteht. Weiterhin ist es hierdurch insbesondere auch möglich, den Abstand zwischen den Längskanten der sich in ihrer Ausgangsposition befindlichen Trennbacken so klein zu halten, daß wenigstens eine Trennbacke beim Einschieben eines zu trennenden Nutzens mit ihrer Längskante in eine Nut eingreift, die an der jeweiligen Trennstelle in den Nutzen eingebracht ist. Hierdurch ist der Nutzen beim Einschieben in den Trennspalt an den Trennbacken geführt ist, was beim Trennen nicht nur die Handhabung wesentlich vereinfacht, sondern auch Fehler vermeidet.

Insbesondere bei horizontaler Anordnung der Längskanten der Trennbacken ist der Antrieb bevorzugt oberhalb des ersten bzw. oberen Trennbackens vorgesehen. Der Antrieb ist dann dadurch weitestgehend gegen Anlagerung von Fremdpartikeln (Staub usw.) geschützt, die (Fremdpartikel) beim Zertrennen der Nutzen in die einzelnen Schaltkreise nicht vermieden werden können und deren Ablagerung im Antrieb die Funktion der Vorrichtung beeinträchtigen würde.

Bei einer bevorzugten Ausführungsform der erfindungsgemäßen Vorrichtung weist der Antrieb einen Elektromotor auf, dessen Drehbewegung vorzugsweise über ein Kniegelenk-Hebelgetriebe in eine Hubbewegung für einen der beiden Trennbacken, vorzugsweise für den ersten Trennbacken umgesetzt wird. Durch die Verwendung eines Elektromotors wird ein geräuscharmer, weich arbeitender Antrieb erzielt, wobei das Kniegelenk-Hebelgetriebe für einen besonders günstigen Weg-Kraftverlauf beim Betätigen des betreffenden Trennbackens sorgt.

Weiterbildungen der Erfindung sind Gegenstand der Unteransprüche.

Die Erfindung wird im folgenden anhand der Figuren an einem Ausführungsbeispiel näher erläutert. Es zeigen:

Fig. 1 in schematischer Darstellung und im Längsschnitt eine Vorrichtung zum Zertrennen des Nutzens in die einzelnen Schaltkreise;

Fig. 2 in schematischer Darstellung einen Schnitt entsprechend der Linie I-I der Fig. 1;

Fig. 3 in vergrößerter Darstellung den zwischen den beiden Trennbacken gebildeten Trennspalt.

Fig. 4 in schematischer Darstellung und in Draufsicht einen vorgeritzten, von mehreren bestückten Schaltkreisen gebildeten Nutzen.

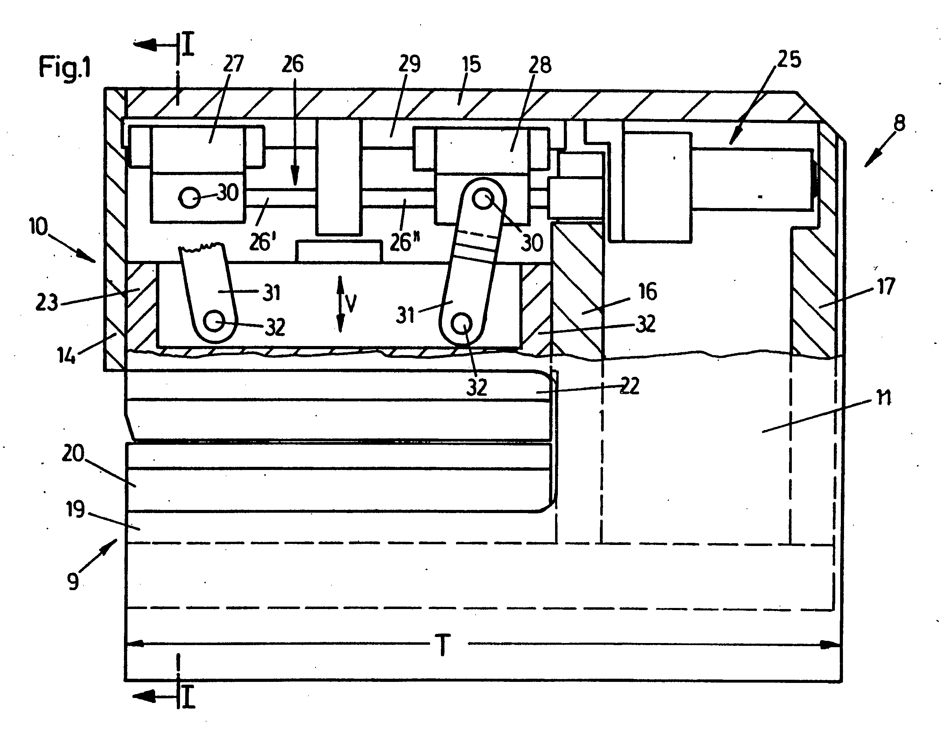

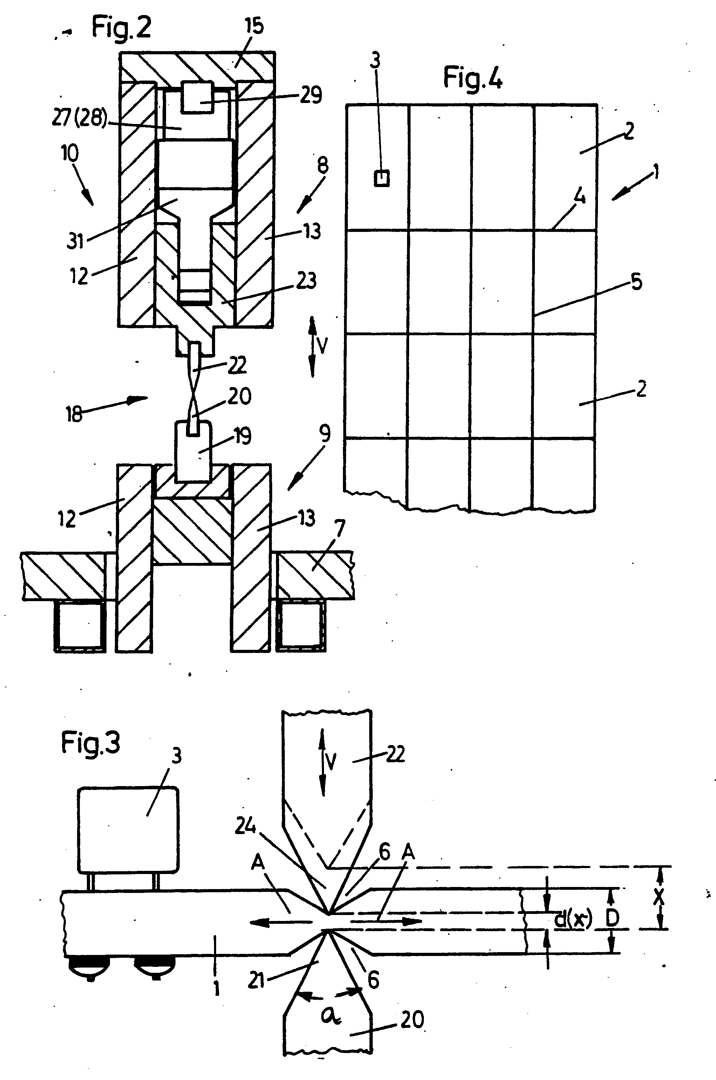

In den Figuren ist 1 ein sogenannter Nutzen in Form einer Kunststoffplatte, auf der eine Vielzahl von elektrischen Schaltkreisen in Form von mit Bauelementen 3 bereits bestückten gedruckten Schaltungen ausgebildet sind. Der einfacheren Darstellung wegen ist von der Vielzahl der die Schaltkreise 2 bildenden Bauelemente 3 in den Figuren lediglich ein Bauelement wiedergegeben. Um ein Trennen des Nutzens 1 in die einzelnen Schaltkreise 2, d.h. ein Vereinzeln dieser Schaltkreise 2 zu ermöglichen, ist der Nutzen 1 an den in der Fig. 4 mit den Linien 4 und 5 angedeuteten Trennstellen beidseitig vorgeritzt, und zwar mit an der Oberseite und der Unterseite des Nutzens 1 vorgesehenen Nuten 6. Zum Zertrennen des Nutzens 1 in die einzelnen Schaltkreise 2 dient die in den Fig. 1 - 3 dargestellte Vorrichtung.

Diese Vorrichtung, die an der Oberseite, d.h. an der horizontalen Arbeitsplatte 7 eines ansonsten nicht näher dargestellten Arbeitsplatzes bzw. -tisches vorgesehen ist, besteht aus einem Vorrichtungsgestell 8, welches einen unteren, an der Arbeitsplatte 7 bzw. am Arbeitstisch befestigten und über die Oberseite der Arbeitsplatte 7 wegstehenden horizontalen Arm 9, einen darüber liegenden, ebenfalls horizontalen Arm 10 sowie einen die beiden Arme 9 und 10 an einem Ende miteinander verbindenden Gestellabschnitt 11 aufweist.

An den beiden Armen 9 und 10 sowie an dem Gestellabschnitt 11 ist das Vorrichtungsgestell 8 jeweils von zwei vertikalen, parallel zueinander und im Abstand voneinander angeordneten Platinen 12 und 13 gebildet, die zumindest im Bereich des oberen Armes 10 sowie im Bereich des Gestellabschnittes 11 durch weitere Platinen bzw. Platten 14, 15, 16 und 17 zu einem geschlossenen Gehäuse ergänzt sind.

Durch die U-förmige Ausbildung des Vorrichtungsgestells 8 mit den beiden Armen 9 und 10 und dem diese Arme an einem Ende miteinander verbindenden Gestellabschnitt 11 ist zwischen der Unterseite des oberen Armes 10 und der Oberseite des unteren Armes 9 ein Arbeitsraum 18 gebildet, der sowohl im Bereich der dem Gestellabschnitt 11 entfernt liegenden und in der Fig. 1 linken Enden der Arme 9 und 10, d.h. an der dortigen Vorder- bzw. Bedienerseite der Vorrichtung, als auch an den beiden Längsseiten dieser Vorrichtung offen ist.

Im Bereich des Arbeitsraumes 18 ist an der Oberseite des unteren Armes 9 bzw. an einem dort vorgesehenen Werkzeughalter 19 ein unterer Trennbacken 20 vorgesehen, der eine obere, horizontale messerschneiden- bzw. keilartige Längskante 21 aufweist, die sich parallel zur Längserstreckung des Armes 9 über die gesamte Länge dieses Armes, d.h. von der Vorder- bzw. Bedienungsseite der Vorrichtung bis an die Platte 16 erstreckt, die den Arbeitsraum 18 an dem Gestellabschnitt 11 begrenzt.

Zusätzlich zu diesem ortsfesten Trennbacken 20 besitzt die Vorrichtung einen weiteren Trennbacken 22, der an der Unterseite des oberen Armes 10 in einer Werkzeughalterung 23 derart befestigt ist, daß die untere, ebenfalls messerschneiden- bzw. keilartig ausgebildete horizontale Längskante 24 des Trennbackens 22 in dem Arbeitsraum 18 in vertikaler Richtung exakt über der Längskante 21 des Trennbackes 20 angeordnet ist, d.h. die Längskanten 21 und 24 liegen in einer gemeinsamen vertikalen Ebene. Jede Längskante 21 und 24 ist von zwei Flächen gebildet, die zwischen sich einen Winkel a einschließen, der kleiner als 30° ist.

Die Werkzeughalterung 23 ist im oberen Arm 10 in vertikaler Richtung, d.h. in Richtung des Doppelpfeiles V und damit in einer Achsrichtung senkrecht zu der Längskante 24 verschiebbar geführt, wobei bei der dargestellten Ausführungsform die vertikalen Innenflächen der Platinen 12 und 13, die ebenfalls vertikale Innenfläche der Platte 14 an der Vorder- bzw. Bedienerseite der Vorrichtung sowie die vertikale, der Vorder- bzw. Bedienerseite zugewendete Oberflächenseite der Platte 16 die Führungs- bzw. Gleitflächen für die Werkzeughalterung 23 bilden.

Für den Hub, d.h. die Auf- und Abbewegung der Werkzeughalterung 23 und damit des Trennbackens 22 ist im Vorrichtungsgestell 8 ein Antrieb vorgesehen, dessen Elemente sich ausnahmslos über dem Arbeitsraum 18 befinden, und zwar dabei speziell im oberen Arm 10 sowie im oberen Teil des Gestellabschnittes 11. Der Antrieb für die Werkzeughalterung 23 weist eine aus einem Getriebe sowie einem Elektromotor bestehende und in der Drehrichtung umschaltbare Antriebseinrichtung 25 auf, die antriebsmäßig mit einer Gewindespindel 26 verbunden ist, die mit ihrer horizontalen Achse in Richtung der Längserstreckung des oberen Armes 10 liegt und in diesem oberen Arm 10 drehbar gelagert ist. Die Gewindespindel 26 besitzt zwei Abschnitte 26′ und 26″. mit gegenläufigem Gewinde, d.h. der Abschnitt 26 ist beispielsweise als Rechtsgewinde und der Abschnitt 26″ als Linksgewinde ausgebildet.

Mit ihrem Abschnitt 26′ greift die Gewindespindel 26 in das Innengewinde eines Gleitkörpers 27 ein. In gleicher Weise wirkt der Abschnitt 26″ mit einem Innengewinde eines Gleitkörpers 28 zusammen. Die beiden Gleitkörper 27 und 28 sind an einer Gleitschiene 29 in horizontaler Richtung und in Richtung der Längserstreckung des Armes 10 verschiebbar geführt. Die Gleitschiene 29 ist an der Unterseite der den Arm 10 oben abschließenden Platte 15 befestigt.

An jedem Gleitkörper 27 bzw. 28 ist mittels Gelenkbolzen 30 das obere Ende eines Hebels 31 gelenkig bzw. schwenkbar befestigt, und zwar um eine horizontale, senkrecht zur Längserstreckung der Trennbacken 20 und 22 bzw. deren Längskanten 21 und 24 verlaufende Achse. Die unteren Enden der Hebel 31 sind mittels Gelenkbolzen 32 an der Werkzeughalterung angelenkt, wobei die Achsen der Gelenkbolzen 32 parallel zu den Achsen der Gelenkbolzen 30 liegen.

Die Fig. 1 und 2 zeigen die Vorrichtung in einem Zustand, in welchem sich der obere Trennbacken 22 in einer oberen Ausgangsstellung befindet und die Längskanten 21 und 24 der beiden Trennbacken 20 und 22 einen Abstand X voneinander aufweisen, der aus Sicherheitsgründen, d.h. zur Vermeidung von Verletzungen bevorzugt nicht größer als 2 mm ist. Vorzugsweise ist dieser Abstand X geringfügig kleiner als die Dicke D des Nutzens 1 bzw. der diesen Nutzen bildenden Platte, aber gleich oder größer ist als die Dicke d, die der Nutzen im Bereich zwischen einer an der Oberseite und einer an der Unterseite des Nutzens vorgesehenen Nut 6 aufweist. In dieser Ausgangsstellung des oberen Trennbackens 22, in der (Ausgangsstellung) der Abstand zwischen den beiden Gelenkbolzen 32 kleiner ist als der Abstand zwischen den beiden Gelenkbolzen 30, beträgt der Abstand X beispielsweise etwa 1,5 mm, und zwar bei einer Dicke D von 1,6 mm. Bei anderen Dicken D werden bevorzugt andere Abstände X verwendet. Dies hat den Vorteil, daß das später noch beschriebene Einschieben des Nutzens 1 zwischen die beiden Trennbacken 20 und 22 ohne Verklemmen möglich ist, gleichzeitig durch die in die Nuten 6 eingreifenden Längskanten 21 und 24 eine Führung des Nutzens an den Trennbacken 20 und 22 erreicht wird.

Die Einstellung des Abstandes x, der bevorzugt 0,05 bis 0,1 mm beträgt, sowie auch das Ausrichten der Längskanten 21 und 24 relativ zueinander derart, daß sie tatsächlich in der gemeinsamen Ebene liegen, erfolgt durch Verstellen des sich nicht bewegenden Werkzeughalters 19. Die Einstellung des Abstandes X bzw. des Öffnungshubes erfolgt beispielsweise dadurch, daß beim Auseinanderbewegen der Trennbacken der Antriebsmotor 25 nach einem vorgegebenen Zeitintervall abgeschaltet wird, und zwar nach einer vorgegebenen Nullposition. Diese Nullposition, die von einem entsprechenden Meßgeber erfaßt wird, ist beispielsweise die Arbeitsstellung des Trennbackens 21. Durch unterschiedliche Wahl der Größe des Zeitintervalles lassen sich dann unterschiedliche Abstände X auf besonders einfache Weise und angepaßt an die jeweilige Dicke D des Nutzens erreichen. Da bei dem Öffnungshub keine besondere Belastung vorliegt, ergeben sich hier eindeutige, reproduzierbare Ergebnisse.

Aus dieser oberen Ausgangsstellung kann der Trennbacken 22 in eine untere Arbeitsstellung bewegt werden, in der die Längskanten 21 und 24 der Trennbacken 20 und 22 immer noch im Abstand voneinander angeordnet sind, d.h. einen Abstand x voneinander aufweisen, der aber kleiner als der Abstand d ist und beispielsweise in der Größenordnung von 0,1 mm liegt. Um den oberen Trennbacken 22 aus der Ausgangsstellung, in der die Achsen der Gelenkbolzen 30 und 32 die Eckpunkte eines gleichschenkligen Trapezes bilden, in die Arbeitsstellung zu bewegen, wird mittels der Antriebseinrichtung 25 die Spindel 26 so gedreht, daß sich die beiden Gleitkörper 27 und 28 und damit auch die dort von den Gelenkbolzen 30 gebildeten Gelenkstellen für die Hebel 31 aufeinander zu bewegen.

Das von den Gleitkörpern 27 und 28 und den Hebeln 31 gebildete Kniegelenkgetriebe ist dabei so ausgelegt, daß die unterste Stellung bzw. Arbeitsstellung des Trennbackens 22, in der (Arbeitsstellung) die Längskanten 21 und 24 den Abstand x voneinander aufweisen, dann erreicht ist, wenn der Abstand der beiden Gelenkbolzen 30 gleich dem Abstand der beiden Gelenkbolzen 32 ist. Hierdurch können sich die Längskanten 21 und 24 maximal nur bis zum Erreichen des Abstandes x annähern.

Zum Trennen des Nutzens 1 in die einzelnen Schaltkreise 2 wird dieser Nutzen von der Bedienerseite her so in den Arbeitsraum 18 bzw. in den zwischen den beiden Trennbacken 20 und 22 gebildeten Spalt eingeschoben, daß diese Trennbacken mit ihren Längskanten 21 bzw. 24 in die vorgeritzten Nuten 6 einer Trennlinie (z.B. Linie 4) des Nutzens 1 eingreifen. Der Trennbacken 22 befindet sich dabei in seiner oberen Hub- bzw. Ausgangsstellung. Durch Einschalten des Antriebs 25 wird der Trennbacken 22 in der vorbeschriebenen Weise nach unten bewegt. Hierbei wird die den Nutzen bildende Platte entlang der betreffenden Linie getrennt, und zwar nicht durch Schneiden des Materials, sondern dadurch, daß die den Nutzen bildende Platte 1 entlang der beiden Nuten 6 bzw. in dem zwischen diesen Nuten liegenden Bereich auseinandergedrückt bzw. auseinandergequetscht wird, wie dies mit den Pfeilen A in der Fig. 3 angedeutet ist. Diese Art der Trennung des Nutzens 1, bei der (Trennung) sich die Längskanten 21 und 24 der Trennbacken 20 und 22 nicht berühren, hat den Vorteil, daß keine den Nutzen 1 verbiegende oder verwindende Kräfte auftreten und sämtliche, beim Trennen ausgeübten Kräfte nur im Bereich zwischen den beiden Nuten 6 der jeweiligen Trennlinie 4 bzw. 5 wirken. Hiermit ist sichergestellt, daß beim Zertrennen des Nutzens 1 in die Schaltkreise 2 letztere nicht beschädigt werden, d.h. insbesondere auch keine Risse in den Leiterbahnen der gedruckten Schaltung dieser Schaltkreise auftreten.

Die einseitig offene Bauweise der Vorrichtung, d.h. die vorbeschriebene Ausbildung der Vorrichtung bzw. des Vorrichtungsgestells 8 in der Weise, daß der Arbeitsraum 18 zur Vorder- bzw. Bedienerseite hin offen ist, ermöglicht es, den Nutzen 1 in der vorbeschriebenen Weise entlang einer Trennlinie 4 bzw. 5 zwischen die Trennbacken 20 und 22 einzuführen, und zwar bei einem minimalen Abstand der Längskanten 21 und 24, und zwar trotz unter Umständen großer und damit weit über zumindest eine Oberflächenseite des Nutzens 1 wegstehender Bauelemente 3. Durch den geringen Abstand X, den die Längskanten 21 und 24 in der Ausgangsstellung des Trennbackens 22 aufweisen und der beispielsweise nur 1,6 mm beträgt, ist eine Verletzungs- und Unfallgefahr praktisch ausgeschlossen, d.h. es ist insbesondere auch möglich, daß das die Vorrichtung bedienende Personal aus Unachtsamkeit mit Fingern zwischen die Trennbacken 20 und 22 greifen kann.

Durch den Kniehebelantrieb für die Werkzeughalterung 23 wird ein optimaler Weg-Kraft-Verlauf erreicht, d.h. am Ende des Arbeitshubs und kurz vor Erreichen des Abstandes x ist in optimaler Weise bei abnehmendem Weg eine extrem hohe Arbeitskraft erreichbar. Die Antriebseinrichtung 25 mit dem antreibenden Elektromotor sorgt weiterhin für einen ruhigen Lauf der Vorrichtung.

Besonders vorteilhaft ist bei der beschriebenen Vorrichtung auch, daß sich die gesamten, bewegten Elemente und der zugehörige Antrieb oberhalb des Arbeitsraumes 18 befinden. Dies schafft nicht nur die Möglichkeit, den Raum unter der Arbeitsplatte 7 als Fußraum für die Bedienungsperson freizuhalten und dadurch den entsprechenden Arbeitsplatz optimal zu gestalten, sondern hierdurch sind die bewegten Elemente und der Antrieb auch gegen die Betriebssicherheit beeinträchtigende Ablagerungen von Staub geschützt, der sich beim Trennen des Nutzens 1 in die Schaltkreise 2 nicht vermeiden läßt.

Ein weiterer Vorteil der beschriebenen Vorrichtung besteht auch noch darin, daß sich diese mit einer relativ geringen Tiefe T fertigen läßt, die den Abstand zwischen der Vorder- bzw. Bedienerseite und der von der Platte 17 gebildeten Rückseite entspricht.

Die Erfindung wurde voranstehend an einem Ausführungsbeispiel beschrieben. Es versteht sich, daß Änderungen sowie Abwandlungen möglich sind, ohne daß dadurch der der Erfindung zugrunde liegende Erfindungsgedanke verlassen wird.

## Ansprüche

1. Vorrichtung zum Zertrennen eines mehrere gedruckte Schaltkreise aufweisenden plattenförmigen Nutzens in die einzelnen Schaltkreise, gekennzeichnet durch einen, an einem Arbeitsraum (18) eines Vorrichtungsgestells (8) vorgesehenen ersten Trennbacken (22), der eine erste, sich in einer ersten, vorzugsweise horizontalen Achsrichtung erstreckende messerschneiden- bzw. keilartige Längskante (24) aufweist, durch einen ebenfalls im Arbeitsraum (18) angeordneten zweiten Trennbacken (20) mit einer zweiten, sich ebenfalls in der ersten Achsrichtung erstreckenden keilartigen Längskante (21) sowie durch einen Antrieb (25 - 31), mit welchem zumindest der erste Trennbacken (22) in einer zweiten, senkrecht zur ersten verlaufenden Achsrichtung zwischen einer Ausgangsposition und einer Arbeitsposition bewegbar ist, wobei die Trennbacken (20, 22) bzw. deren Längskanten (21, 24) in beiden vorgenannten Positionen einen Abstand voneinander, in der Arbeitsposition jedoch einen Abstand (x) voneinander aufweisen, der kleiner ist als der Abstand (X) in der Ausgangsposition, wobei der Arbeitsraum (18) in einer dritten, senkrecht zur ersten sowie senkrecht zur zweiten verlaufenden, vorzugsweise horizontalen Achsrichtung sowie in der ersten Achsrichtung an einem Ende der Längskanten (21, 24) der Trennbacken (20, 22) offen ist.

2. Vorrichtung nach Anspruch 1, dadurch gekennzeichnet, daß die Trennbacken (20, 22) mit ihren Längskanten (21, 22) parallel zueinander und in einer gemeinsamen Ebene liegend relativ zueinander bewegbar sind.

3. Vorrichtung nach Anspruch 1 oder 2, dadurch gekennzeichet, daß der Antrieb (25 - 31) außerhalb des Arbeitsraumes (18) an der der ersten Längskante (24) abgewandten Seite des ersten Trennbackens (22) vorgesehen ist, und daß der erste Trennbacken (22) in vertikaler Richtung über dem zweiten Trennbacken (20) angeordnet ist und sich der Antrieb (25, 32) oberhalb des ersten Trennbackens (22) befindet.

4. Vorrichtung nach einem der Ansprüche 1 bis 3, dadurch gekennzeichnet, daß zum Antrieb des ersten Trennbackens (22) bzw. einer diesen Trennbacken aufweisenden Werkzeughalterung (23) ein von einem Motor (25) angetriebenes Kniehebelgetriebe (26 - 32) vorgesehen ist,

wobei vorzugsweise das Kniehebelgetriebe wenigstens einen am Vorrichtungsgestell (8) in einer senkrecht zur zweiten Achsrichtung, bevorzugt in der ersten Achsrichtung verschiebbar geführten Gleitkörper (27, 28) aufweist, an welchem ein Kniegelenkhebel (31) mit einem Ende angelenkt ist, dessen anderes Ende an den ersten Trennbacken bzw. an der diesen ersten Trennbacken aufweisenden Werkzeughalterung (23) angelenkt ist.

5. Vorrichtung nach Anspruch 4, gekennzeichnet durch zwei in der gleichen Achsrichtung am Vorrichtungsgestell (8) geführte Gleitkörper (27, 28), die durch den Motor (25) vorzugsweise gegenläufig bewegbar sind und von denen jeder über einen Kniegelenkhebel (31) mit dem ersten Trennbacken (22) bzw. mit der zugehörigen Werkzeughalterung (23) gelenkig verbunden ist.

6. Vorrichtung nach Anspruch 4 oder 5, dadurch gekennzeichnet, daß zum Verschieben der Gleitkörper (27, 28) diese mit einem Gewindestück in jeweils einen Abschnitt (26', 26'') einer von dem Motor (25) angetriebenen Gewindespindel (26) eingreifen,

wobei vorzugsweise von den beiden Gleitkörpern (27, 28) ein Gleitkörper mit einem ein Linksgewinde aufweisenden Abschnitt und ein Gleitkörper mit einem ein Rechtsgewinde aufweisenden Abschnitt der Gewindespindel (26) zusammenwirkt.

7. Vorrichtung nach einem der Ansprüche 1 bis 6, dadurch gekennzeichnet, daß der Vorrichtungsgestell (8) einen unteren, mit seiner Längserstrekkung in der ersten Achsrichtung liegenden Arm (9) und einen oberen, mit seiner Längserstreckung ebenfalls in der ersten Achsrichtung liegenden Arm (10) aufweist, zwischen denen der Arbeitsraum (18) gebildet ist und die nur an einem Ende über einen Gestellabschnitt (11) miteinander verbunden sind, und daß im Bereich der Oberseite des unteren Armes (9) der zweite Trennbacken (20) und im Bereich der Unterseite des oberen Armes (10) der erste Trennbacken bzw. eine an diesem oberen Arm verschiebbar geführte Werkzeughalterung (23) vorgesehen sind,

wobei vorzugsweise zumindest der wenigstens eine Gleitkörper (27, 28) sowie der wenigstens eine Kniegelenkhebel (31) des Antriebs in dem oberen Arm (10) untergebracht sind.

8. Vorrichtung nach einem der Ansprüche 1 bis 7, dadurch gekennzeichnet, daß die erste sowie die zweite Längskante (24, 21) in der Ausgangsposition einen Abstand (X) voneinander aufweisen, der kleiner ist als die Dicke des plattenförmigen Nutzens (1), wobei dieser Abstand (X) vorzugsweise einstellbar ist, und zwar beispielsweise durch Einstellung einer bestimmten Zeit für den Öffnungshub.

9. Vorrichtung nach einem der Ansprüche 1 bis 8, dadurch gekennzeichnet, daß der Abstand (x) der beiden Längskanten (21, 24) in der Arbeitsposition einstellbar, vorzugsweise zwischen etwa 0,05 bis 0,1 mm einstellbar ist.

10. Vorrichtung nach einem der Ansprüche 1 bis 9, dadurch gekennzeichnet, daß die keilartige Längskante (21, 24) jedes Trennbackens (20, 22) von zwei einen Winkel (a) kleiner als 30° einschließenden Flächen gebildet ist.

Fig.1

EP 0 381 088 A1

EP 0 381 088 A1

Fig.2

Fig.4

Fig.3

## EINSCHLÄGIGE DOKUMENTE

EP 90101651.9

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| A | EP - A2 - 0 222 401 (FUJITSU) * Zusammenfassung; Fig. 1-66 * | 1 | H 05 K 13/00 |
| A | DE - A1 - 2 926 865 (HONEYWELL) * Patentansprüche 1-38; Fig. 1-20 * | 1 | |
| A | EP - A1 - 0 131 809 (FUJITSU) * Zusammenfassung; Fig. 1-8 * | 1 | |
| A | US - A - 4 742 615 (LOPEZ) * Zusammenfassung; Fig. 1 * | 1 | |
| A | DD - A1 - 242 574 (VEB ELEKTROPHYSIKALISCHE WERKE) * Zusammenfassung; Fig. 1 * | 1 | |

RECHERCHIERTE
SACHGEBIETE (Int Cl⁵)

H 05 K 13/00
H 05 K  3/00

Der vorliegende Recherchenbericht wurde für alle Patentansprüche erstellt.

| Recherchenort | Abschlußdatum der Recherche | Prüfer |
|---|---|---|
| WIEN | 22-03-1990 | VAKIL |